Europäisches Patentamt

European Patent Office

Office européen des brevets

(19)

(11) Veröffentlichungsnummer: **0 213 409 B1**

(12) **EUROPÄISCHE PATENTSCHRIFT**

(45) Veröffentlichungstag der Patentschrift: **04.09.91**

(51) Int. Cl.5: **H01L 23/52**, H01L 21/66

(21) Anmeldenummer: **86110622.7**

(22) Anmeldetag: **31.07.86**

(54) **Struktur zur Qualitätsprüfung einer Substratscheibe aus Halbleitermaterial.**

(30) Priorität: **27.08.85 DE 3530578**

(43) Veröffentlichungstag der Anmeldung:
**11.03.87 Patentblatt 87/11**

(45) Bekanntmachung des Hinweises auf die
Patenterteilung:
**04.09.91 Patentblatt 91/36**

(84) Benannte Vertragsstaaten:
**DE FR GB NL**

(56) Entgegenhaltungen:
**EP-A- 0 113 828**
**EP-A- 0 119 059**

**ELECTRONIC ENGINEERING, Band 54, Nr. 663, März 1982, Seiten 53-57, London, GB: " A joint course. Designing with ULA's. Part 1. Technology and circuit elements"**

**THE 2ND INTERNATIONAL CONFERENCE ON SEMI-CUSTOM ICs, November 1982, Seiten 1-7, London, GB: "Introduction of an ultra fast 8000-gate CMOS gate array"**

(73) Patentinhaber: **Siemens Aktiengesellschaft**
**Wittelsbacherplatz 2**
**W-8000 München 2(DE)**

(84) Benannte Vertragsstaaten:
**DE GB NL**

Patentinhaber: **N.V. Philips' Gloeilampenfabrieken**
**Groenewoudseweg 1**
**NL-5621 BA Eindhoven(NL)**

(84) Benannte Vertragsstaaten:
**DE GB NL**

Patentinhaber: **LABORATOIRES D'ELECTRONIQUE PHILIPS**
**3, Avenue Descartes**
**F-94450 Limeil-Brévannes(FR)**

(84) Benannte Vertragsstaaten:
**DE FR GB NL**

(72) Erfinder: **Packeiser, Gerhard, Dipl.-Phys. Dr.**
**Am Brunnen 1**
**W-8011 Kirchheim(DE)**

Anmerkung: Innerhalb von neun Monaten nach der Bekanntmachung des Hinweises auf die Erteilung des europäischen Patents kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

IEEE 1983 INTERNATIONAL SYMPOSIUM ON CIRCUITS AND SYSTEMS, Newport Beach, California, US, 2.-4. Mai 1983, Seiten 1009-1012, IEEE, New York, US; J. CHEAM et al.: "Routing techniques for gate array layout"

Erfinder: **Schink, Helmut, Dipl.-Phys. Dr.**
**Knappertsbuschstrasse 5**
**W-8000 München 81(DE)**
Erfinder: **Martin, Gerard Marie**
**23 rue de Moscou**
**F-75008 Paris(FR)**
Erfinder: **Maluenda, Jose**
**2 Place de la Peupleraie**
**F-94470 Boissy Saint Leger(FR)**

(74) Vertreter: **Fuchs, Franz-Josef, Dr.-Ing. et al**
**Postfach 22 13 17**
**W-8000 München 22(DE)**

## Beschreibung

Die vorliegende Erfindung bezieht sich auf eine Struktur zur Qualitätsprüfung von aus einem größeren Halbleiterkristall hergestellten Substratscheibe, die der weiteren Herstellung von Chips mit integrierten Schaltungen (IC's) dienen. Eine solche Struktur umfaßt Feldeffekttransistor-Strukturen, Leiterbahnen und Pads.

Aus "Electronic Engineering", Bd. 54, No. 663, März 1982, S. 53 bis 57, sind Hinweise zur Technologie und zu Schaltkreiselementen bekannt. Es sind dort allgemeine Hinweise zu integrierten Schaltungsbeispielen gegeben, z.B. zu Gate Arrays, master slices oder Logik-Arrays. Insbesondere handelt es sich dort um das Design der Zusammenschaltung der ein solches Array bildenden einzelnen Halbleiterfunktions-Elemente. Es sind dort Angaben über die Leitungsführung solcher in der Praxis als Schaltung zu verwendenden integrierten Schaltungen gemacht.

Aus "The 2ND International Conference on Semi-Custom ICs", Nov. 1982, S. 1 bis 7, ist eine Einführung in ultraschnelle 8000-Gate CMOS Gate-Arrays gegeben. Auch in dieser Druckschrift sind hochintegrierte Schaltungen abgehandelt, wie sie auf Halbleiterchips entsprechender Größe realisiert werden. Fraglos ist es wichtig, daß das Material eines Halbleiterchips, das eine solche hochintegrierte Schaltung trägt, eine solche Homogenität und Fehlerfreiheit besitzt, daß jedes einzelne Funktionselement dieser integrierten Schaltung funktionstüchtig ist. Der Ausfall schon einer einzigen Funktion kann die ganze integrierte Schaltung bzw. den ganzen Halbleiterchip wertlos machen.

Es ist gängige Praxis, für Halbleiterschaltungen zu verwendende Substratscheiben vor der Herstellung der Halbleiterchips auf ihre Brauchbarkeit und Fehlerfreiheit zu überprüfen. Eine solche Substratscheibe ist eine größere, im Regelfall bis zu einige Zoll Durchmesser aufweisende, jedoch sehr dünne Scheibe, die aus einem gezüchteten Halbleiterkristall durch vorzugsweise Sägen gewonnen worden ist. Ein derartiger Halbleiterkristall wird durch eine Vielzahl von parallelen Sägeschnitten in derartige Substratscheiben zerteilt. Die Qualitätsprüfung wird üblicherweise stichprobenartig durchgeführt. Es hat sich erwiesen, daß das Ergebnis der Qualitätsprüfung einer Substratscheibe gültige Aussage auch für aus dem Kristall benachbart gewonnen Substratscheiben macht.

Ein bekanntes Verfahren der Qualitätsprüfung ist, eine dafür vorgesehene solche Struktur auf der Substratoberfläche herzustellen, die in einem Rasterabstand von etwa 200 $\mu$m Feldeffektransistor-Strukturen besitzt, die unmittelbar umgeben sind von den zugehörigen Anschlußpads. Insbesondere kann vorgesehen sein, daß der eine Source/Drain-Bereich des einen Transistors auch Source/Drain-Bereich des benachbarten Transistors ist, so daß in lateraler Richtung zwischen zwei benachbarten Gate-Bereichen jeweils nur ein einziger Source/Drain-Bereich mit seinem jeweils relativ großflächigen Anschlußpad vorhanden ist. Mit einer solchen Struktur wird z.B. die gesamte Oberfläche einer einzelnen Substratscheibe bedeckt und damit diese einzelne Substratscheibe lückenlos im angegebenen Rastermaß überprüft. Von dieser geprüften Substratscheibe wird dann auf eine größere Anzahl benachbart aus dem Kristall geschnittenen Substratscheiben geschlossen. Es kann auch vorgesehen sein, auf einer Substratscheibe einen kleineren Ausschnittsbereich mit einer derartigen Struktur hinsichtlich der Qualität zu überprüfen, wobei dieser Ausschnittsbereich (ebenso wie die voranstehend erwähnte einzelne Substratscheibe) für die Produktion von integrierten Schaltungen nicht mehr zu verwenden ist und als Chip ausgesondert wird.

Das mit dem für das voranstehend beschriebene Verfahren und dessen Varianten angewendeten Rastermaß erzielte Ergebnis der Qualitätsprüfung ist insbesondere für Silizium als Halbleitermaterial an sich relativ zufriedenstellend. Insbesondere aber für Halbleitermaterial des Typs der III-V-Verbindungen (Galliumarsenid, Galliumphosphid, Indiumphosphid und dgl. aber auch ternäre und quaternäre Misch-Halbleiter, wie Galliumaluminiumarsenid, Galliumarsenidphosphid und dgl.) bedarf es -wie dies ein Ausgangspunkt für die der Erfindung zugrundeliegenden Gedanken ist- einer verfeinerten Qualitätsprüfung. Speziell für die binären, ternären und quaternären III-V-Halbleitermaterialien wurde festgestellt, daß Qualitätsmängel vorliegen können, die mit einem z.B. 200-$\mu$m-Raster nicht mit ausreichender Zuverlässigkeit erfaßt werden können. Trotz dieser Feststellung gilt aber, daß von dem Prüfungsergebnis für eine Substratscheibe auf die aus dem Kristall benachbart gewonnen weiteren Substratscheiben geschlossen werden kann.

Aufgabe der vorliegenden Erfindung ist es, ein insbesondere für III-V-Halbleitermaterial geeignetes Verfahren der Qualitätsprüfung anzugeben, das zuverlässigere Aussagen macht. Diese Aufgabe wird mit einer Struktur nach dem Patentanspruch 1 gelöst und weitere Ausgestaltungen und Weiterbildungen der Erfindung gehen aus den Unteransprüchen hervor.

Der Erfindung liegt der Gedanke zugrunde, daß eine Struktur zur Qualitätsprüfung eine derartige Feinheit bzw. Dichte haben muß, die mindestens eben so groß oder noch feiner bzw. dichter ist, als das Raster der einzelnen Funktionselemente eines integrierten Schaltkreises, der auf bzw. in (einem Chip aus) der Substratscheibe (fabrikationsgemäß) herzustellen ist. Nur dann, wenn die Qualitätsprüfung mit der durch die Erfindung erzielten Feinheit erfolgt, ist ausreichend zuverlässige Aussage über bzw. ausreichend zuverlässige Auswahl hinsichtlich in der Produktion zu verwendender Substratscheiben zu machen. Die erfindungsgemäße Struktur hat dementsprechend eine Vielzahl von Feldeffekttransistor-Strukturen, die lateral wenigstens so dicht nebeneinander angeordnet sind, wie Feldeffekttransistoren in einer (fabrikationsmäßig) herzustellenden integrierten Schaltung (auf dem Chip) angeordnet sind. Dabei hat sich erwiesen, daß ausreichend ist, mit dieser Feinheit entlang einer Richtung auf der Substratoberfläche zu prüfen. Es empfiehlt sich jedoch, die vorgesehene Qualitätsprüfung mit mehreren erfindungsgemäßen Strukturen durchzuführen und diese auf der Oberfläche der betreffenden Substratscheibe in verschiedenen Richtungen orientiert anzuordnen.

Auch bei der Erfindung kann so verfahren werden, daß eine einzelne Substratscheibe über ihre ganze Fläche hinweg mit (nebeneinander angeordneten) erfindungsgemäßen Strukturen überprüft wird oder es wird nur ein jeweiliger Flächenausschnitt der Substratscheibe geprüft. Welche Maßnahme zu bevorzugen ist, leitet der Fachmann z.B. der Einfachheit halber aus Testprüfungen ab.

Bei der erfindungsgemäßen Struktur sind die Feldeffekttransistor-Strukturen dicht an dicht nebeneinander angeordnet. Jede einzelne Feldeffekttransistor-Struktur hat für sich allein eine eigene Source-Struktur und eine eigene Drain-Struktur. Für diese jeweils zwei Strukturen und die zugehörige Gate-Struktur jeder einzelnen Feldeffekttransistor-Struktur ist eine eigene Wannenstruktur vorgesehen, wobei diese Wannenstrukturen gemäß der Anordnung der Feldeffekttransistor-Strukturen entsprechend lateral dicht nebeneinander angeordnet sind.

Einzelne Zuleitungs-Leiterbahnen sind erforderlich für die Source-Struktur und für die Drain-Struktur, und zwar jeder einzelnen Feldeffekttransistor-Struktur. Bei der Erfindung sind lediglich die Gate-Strukturen aller oder jeweils wenigstens einer größeren Anzahl der Feldeffekttransistor-Strukturen elektrisch miteinander verbunden. Jede einzelne der Zuleitungs-Leiterbahnen besitzt an ihrem der jeweiligen Feldeffekttransistor-Struktur entgegengesetzten Ende ein Anschlußpad für z.B. das Aufsetzen von Prüfspitzen. Bei der Erfindung sind diese Anschlußpads im Randbereich der gesamten Struktur angeordnet. Dies bedingt, daß zumindest einige der Source-Strukturen und/oder Drain-Strukturen einzelner Feldeffekttransistor-Strukturen Zuleitungs-Leiterbahnen zwischen diesen Strukturen und deren Pads haben, die relativ große Länge besitzen. Bei der Erfindung ist vorgesehen, daß alle diese Source/Drain-Struktur und zugehöriges Pad verbindenden Leiterbahnen im wesentlichen,d. h. soweit genügend gleich großen Leiterbahnwiderstand haben, daß Unterschiede im Leiterbahnwiderstand auf die Messung der Werte der Einsatzspannung der Feldeffekttransistoren noch keinen für die Qualitätsbeurteilung nachteiligen Einfluß haben. Dies ist (bei zwangsläufig vorgegebener Länge) durch entsprechende Bemessung von Breite und/oder Dicke der einzelnen Leiterbahn zu erreichen. Insbesondere kann aber auch vorgesehen sein, daß in eine jeweilige Leiterbahn eine zusätzliche Mäanderstruktur zur Wegverlängerung eingefügt ist.

Für die Gate-Strukturen genügt an sich eine einzige Zuleitungs-Leiterbahn. Von Vorteil ist jedoch hierfür zwei Leiterbahnen zu verwenden, die von beiden Seiten den (nebeneinander angeordneten) Gate-Strukturen zugeführt sind und insbesondere im Bereich dieser Gate-Strukturen miteinander verbunden sind. Dies hat unter anderem auch den Vorteil, daß eine im Bereich der Gate-Strukturen versehentlich entstandene Unterbrechung der Gate-Leiterbahn praktisch keinen nachteiligen Einfluß hat. Für die Kontaktierung mit den Gate-Strukturen, d.h. für den Gate-Kontakt auf dem Halbleitermaterial der Substratscheibe, ist jeweils ein Gate-Schottky-Kontakt vorgesehen.

Insbesondere ist bei der Erfindung vorgesehen, auf der Oberfläche der Substratscheibe keine Isolationsschicht vorzusehen und/oder keine Ätzstrukturen in deren Oberfläche anzubringen. Aufgebrachte Isolationsschichten und/oder eingefügte Ätzstrukturen können, z.B. durch dadurch erzeugte Spannungen im Halbleitermaterial, ein falsches Bild von der Qualität der ursprünglichen Substratscheibe geben.

Das Weglassen von Isolationsschichten bedingt kreuzungsfreie Anordnung der Leiterbahnen und dies ist ein fakultatives Merkmal einer erfindungsgemäßen Struktur.

Die Erfindung kann in jeweils etwas verschiedener Realisierung bzw. Verkörperung auftreten. Zum Beispiel kann diese erfindungsgemäße Struktur bereits auf einer Substratscheibe aufgebracht bzw. vorhanden sein, wobei die Wannenstrukturen und Source/Drain-Strukturen (diffundiert bzw. implantiert) dotierte Bereiche der Oberfläche der Substratscheibe sind, die Gate-Strukturen Schottky-Kontakte sind und die Leiterbahnen und Pads Metallisierungsbeschichtungen der Oberfläche der Substratscheibe sind. Diese Verkörperung der Erfindung liegt im Stadium der Durchführung der vorgesehenen Qualitätsprüfung vor.

Die voranstehend beschriebene Herstellung der erfindungsgemäßen Struktur auf der Oberfläche der Substratscheibe kann unter Verwendung von Masken und/oder unter Anwendung eines Strahl-Schreibverfahrens (z.B. Elektronenstrahlschreiben) durchgeführt werden. Die Erfindung liegt dementsprechend bereits verkörpert in einem Satz Masken vor, der zur Herstellung der erfindungsgemäßen Struktur auf der Substratoberfläche im maskentechnologischen Herstellungsverfahren verwendet wird. Eine erste Maske dieses Satzes enthält z.B. die geometrischen Abgrenzungen der Wannenstruktur. Eine zweite Maske enthält die geometrische Struktur der Source/Drain-Bereiche. Diese beiden Masken sind Dotierungsmasken. Eine andere Maske enthält die Struktur der Leiterbahnen und Pads, wobei diese Maske im Bedampfungs- bzw. Sputter-Prozeß oder dgl. verwendet wird. Eine noch weitere Maske enthält die Struktur der Gate-Strukturen.

Der jeweils verwendete Ausdruck "Struktur" im Zusammenhang mit Source/Drain-Struktur, Gate-Struktur, Feldeffekttransistor-Struktur, aber auch als erfindungsgemäße "Struktur zur Qualitätsprüfung", ist somit je nach erreichtem Fortschritt in der Durchführung des Erfindungsgedankens verschiedenartig verkörpert, ohne daß jedoch die darin enthaltene Erfindungsidee verschiedenartig wäre. Gleiches gilt für die Erscheinungsform der Merkmale der Unteransprüche, z.B. daß keine Maske für die Herstellung einer Ätzstruktur oder Isolationsschicht vorgesehen ist, die eine Maske eine jeweilige Mäanderstruktur und/oder entsprechend unterschiedliche Breite für die einzelne Leiterbahn enthält und dgl.

Weitere Erläuterungen der Erfindung gehen aus der nachfolgenden Beschreibung eines Ausführungsbeispiels der Erfindung hervor.

Figur 1a, 1b zeigt eine Gesamtübersicht über eine dem erfindungsgemäßen Prinzip entsprechende Struktur, wie sie bereits auf der Oberfläche einer Substratscheibe ausgeführt ist.

Figur 2 zeigt in erheblich vergrößertem Ausschnitt den zentralen Bereich der Struktur, und zwar mit vier wie für die Erfindung vorgesehen nebeneinander angeordneten Feldeffekttransistor-Strukturen.

Figur 3 zeigt in gegenüber Figur 1 erheblich verkleinertem Maßstab eine Substratscheibe, auf der in einzelnen abgegrenzten Oberflächenbereichen eine erfindungsgemäße Struktur aufgebracht ist.

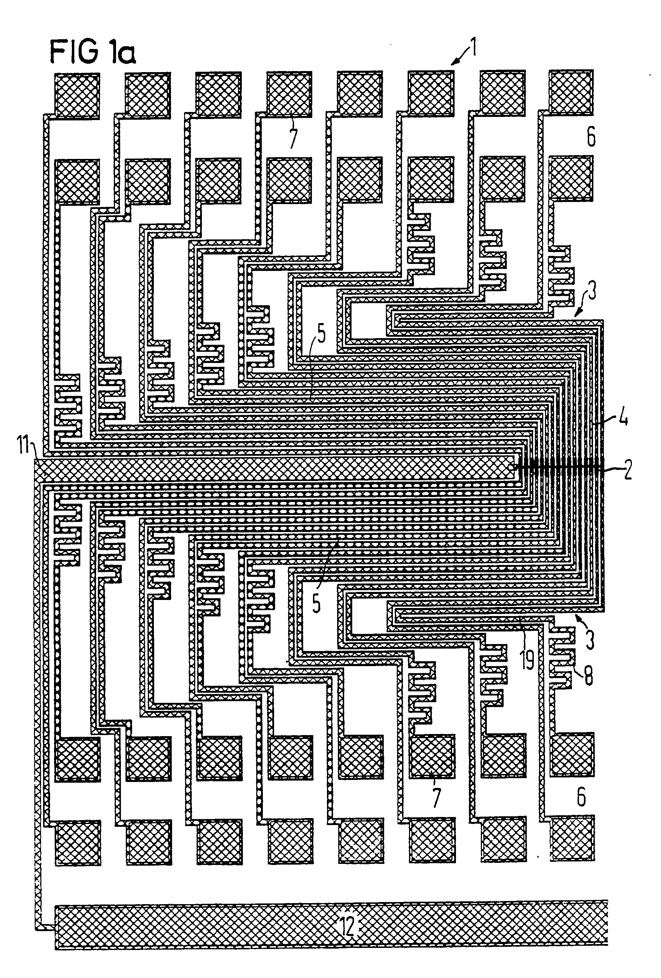

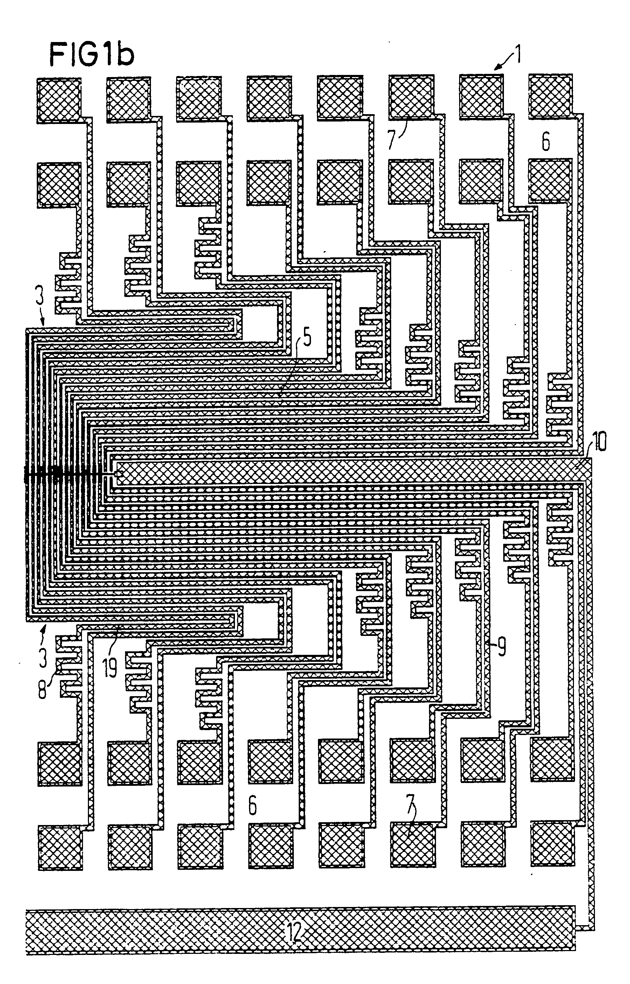

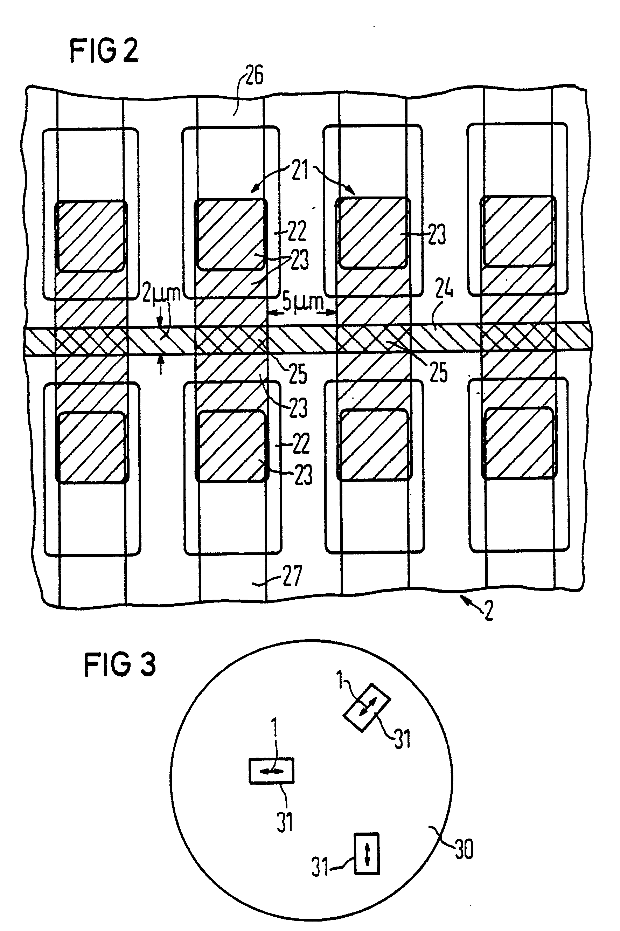

Figur 1a,1b zeigt eine gesamt erfindungsgemäße Struktur 1. Mit 2 ist in dieser Struktur die Gesamtanordnung der vorgesehenen Anzahl, z.B. 30, Feldeffektransistor-Strukturen bezeichnet, die lateral dicht nebeneinander angeordnet sind. Der besseren Übersichtlichkeit halber ist diese Nebeneinanderanordnung 2 als zeichnerisch nicht näher detaillierter Streifen dargestellt. Die in Figur 1 fehlenden Einzelheiten dieses Streifens sind in Figur 2 vergrößert dargestellt. Der Mittenabstand zweier Feldeffekttransistor-Strukturen in der Nebeneinanderanordnung 2 beträgt z.b. 5 bis 20 μm, insbesondere I0 μm. Die Breite einer einzelnen Feldeffekttransistor-Struktur beträgt z.B. 3 bis 10

μm, vorzugsweise 5 μm. Entsprechender seitlicher Abstand von z.B. 2 bis 10 μm, vorzugsweise 5 μm ergibt sich daraus für die nachfolgend zu erörternden Leiterbahnen im Bereich der Anschlüsse an die Source/Drain-Strukturen.

Mit 3 ist die Gesamtheit der Leiterbahnen bezeichnet. Als Anteil dieser Gesamtheit ist mit 4 der Anteil bezeichnet, der die den Source/Drain-Bereichen nahe befindlichen Leiterbahnanteile umfassen. An der Grenze dieser Bereiche 4 mit der streifenförmigen Nebeneinanderanordnung 2 befinden sich die Kontaktverbindungen zwischen einer jeweiligen Leiterbahn und der jeweils einen einzigen Source/Drain-Struktur einer einzelnen Feldeffekttransistor-Struktur. Entsprechend der Aneinanderreihung der Feldeffekttransistor-Strukturen in der streifenförmigen Nebeneinanderanordnung 2 teilt sich dieser Bereich 4 in die beiden aus der Figur 1 ersichtlichen Anteile (in Figur 1 oberhalb und unterhalb des Streifens 2) auf. In diesen Bereichen 4 haben die einzelnen Leiterbahnen relativ geringe Breite.

Breitere Leiterbahnen können in den Teilbereichen 5 der Gesamtheit 3 der Leiterbahnen vorgesehen sein. Mit 6 sind die Randbereiche der Struktur bezeichnet, in denen sich die Anschlußpads 7 befinden. Mit 8 sind mäanderförmige Wegverlängerungen bezeichnet, die der erwähnten Egalisierung des Leiterbahnwiderstandes dienen. Auch die aus der Figur ersichtlichen, mehr oder weniger rechteckförmigen Führungen 9 bzw. Hin- und Herführungen 19 einzelner Leiterbahnen dienen diesem Zweck der Egalisierung.

Mit 10 und 11 sind die beiden Anteile einer Gate-Zuleitungs-Leiterbahn bezeichnet, zu denen das Anschlußpad 12 gehört. Diese beiden Leiterbahnen 10 und 11 führen von je einer Seite zur Nebeneinanderanordnung 2 der Feldeffekttransistor-Strukturen. Wie aus Figur 2 näher ersichtlich, gehen beide Leiterbahnen 10 und 11 in eine gemeinsame Gate-Leiterbahn im Bereich der Nebeneinanderanordnung 2 über.

Es ist ersichtlich, daß mit der Struktur nach Figur 1 jede einzelne Feldeffekttransistor-Struktur für sich getrennt untersucht werden kann und insbesondere deren für die Qualitätsbeurteilung besonders wichtige Größe der Einsatzspannung individuell festgestellt werden kann. Dabei hat die örtliche Dichte der einzelnen Feldeffekttransistor-Strukturen (im Flächenbereich der Nebeneinanderanordnung 2) eine Dichte, die wenigstens so groß ist, wie sie für die einzelnen Funktionselemente in einer integrierten Schaltung eines Chips aus einer solchen Substratscheibe vorgesehen ist.

Figur 2 zeigt einen vergrößerten Ausschnitt aus der Nebeneinanderanordnung 2 der Figur 1. Darin ist für eine jede einzelne Feldeffekttransistor-Struktur 21 eine jeweilige Wannenstruktur 23 vorgesehen, die in der (im Regelfall an sich isolierenden oder wenigstens relativ hochohmigen) Substratscheibe ein dotierter Bereich ist. Innerhalb einer jeweiligen Wannenstruktur 23 sind die Source/Drain-Strukturen 22 angeordnet. Auch diese sind integrierten Schaltungen entsprechend zu dotierende, nachfolgend also dotierte Bereiche der Substratscheibe. Mit 24 ist die Gate-Leiterbahn bezeichnet, die an ihren beiden (in Figur 2 rechtsseitig und linksseitig gelegenen) Enden in die Leiterbahn 10 bzw. 11 übergeht. Die eigentlichen Gate-Bereiche bzw. Gate-Strukturen der einzelnen Feldeffekttransistor-Strukturen sind mit 25 bezeichnet. Dort entfaltet der erwähnte Gate-Schottky-Kontakt seine vorgesehene Wirkung. Mit 26 und 27 sind die Anschlußenden der zu den Source/Drain-Strukturen führenden Leiterbahn-Strukturen bezeichnet. Diese Leiterbahn-Strukturen 26 und 27 gehen in die in Figur 1 mit 4 bezeichneten Leiterbahn-Strukturen über.

Figur 3 zeigt eine an sich bekannte Substratscheibe 30, mit z.B. 2 Zoll Durchmesser, und zwar in Aufsicht. Mit 31 sind drei Flächenanteile der Oberfläche der Substratscheibe 30 bezeichnet, in denen für die Durchführung der Qualitätsprüfung mit einer erfindungsgemäßen Struktur dort eine solche erfindungsgemäße Struktur auf der Oberfläche der Substratscheibe 30 realisiert ist. Mit 1 ist auf die jeweilige Orientierung der Struktur 1 der Fig. 1 in dem jeweiligen Flächenanteil 31 hingewiesen.

## Patentansprüche

1. Struktur zur Qualitätsprüfung von aus einem größeren Halbleiterkristall hergestellten Substratscheiben (30) aus Halbleitermaterial, die als Ausgangsmaterial für daraus herzustellende Chips bestimmt sind, wobei die Chips für eine auf ihnen herzustellende, integrierte Schaltung mit in vorgegebener Dichte angeordneten Feldeffekttransistoren vorgesehen sind, wobei diese Struktur auf bzw. in die Oberfläche der Substratscheibe (30) auf- bzw. eingebracht ist und diese Struktur Feldeffekttransistor-Strukturen (21) Leiterbahn-Strukturen (3) und Pad-Strukturen (6) umfaßt, **gekennzeichnet dadurch,**
   - daß eine Vielzahl von Feldeffekttransistor-Strukturen (21) lateral wenigstens so dicht nebeneinander angeordnet ist wie die Feldeffekttransistoren in der auf dem entsprechenden Chip herzustellenden integrierten Schaltung angeordnet sind,
   - daß eine jede Feldeffekttransistor-Struktur (21) für sich allein je eine eigene Wannenstruktur (23) und eine eigene Source- und eigene Drain-Struktur (22) hat,
   - daß den einzelnen Feldeffekttransistor-Strukturen (21) individuell zugehörige Pad-Strukturen (7) im Randbereich (6) der Struktur angeordnet sind,
   - daß jede einzelne Source/Drain-Struktur (22) mit der jeweiligen Pad-Struktur (7) durch eine eigene Leiterbahn (3) verbunden ist, wobei die Gesamtheit dieser Leiterbahnen in Breite und/oder Länge so bemessen ist,
   daß jeweils ein für die Qualitätsbeurteilung genügend, gleich großer Leiterbahnwiderstand vorliegt und
   - daß nur eine gemeinsame Gate-Leiterbahn (10, 11, 24) vorgesehen ist.

2. Struktur nach Anspruch 1, **gekennzeichnet dadurch**, daß bezogen auf die Nebeneinanderanordnung (2) der Feldeffekttransistor-Strukturen (21) beidseitige Zuführung (10, 11) der Gate-Leiterbahn-Struktur vorgesehen ist.

3. Struktur nach Anspruch 1 oder 2, **gekennzeichnet dadurch**, daß ein Schottky-Gate-Kontakt vorgesehen ist.

4. Struktur nach Anspruch 1, 2 oder 3, **gekennzeichnet dadurch**, daß in den Leiterbahnen (3) eine Wegverlängerung in Form einer Mäanderstruktur (8) vorgesehen ist.

5. Struktur nach Anspruch 1, 2 oder 3, **gekennzeichnet dadurch**, daß in den Leiterbahnen (3) eine Wegverlängerung in Form einer Hin- und Herführung (l9) vorgesehen ist.

6. Struktur nach einem der Ansprüche 1 bis 5, **gekennzeichnet durch** eine kreuzungsfreie Anordnung der Leiterbahnen

7. Struktur nach einem der Ansprüche 1 bis 6, **gekennzeichnet durch** eine isolationsschichtfreie Ausführung.

8. Struktur nach einem der Ansprüche 1 bis 7, **gekennzeichnet durch** eine ätzstruktur-freie Oberfläche der Substratscheibe (30).

9. Struktur nach einem der Ansprüche 1 bis 8, **gekennzeichnet** dadurch, daß die jeweilige Wannenstruktur (23) ein leitend dotiertes Gebiet ist.

10. Struktur nach einem der Ansprüche 1 bis 9 **gekennzeichnet** dadurch, daß das die jeweilige Wannenstruktur (23) umgebende Halbleitermaterial elektrisch isolierend ist.

## Claims

1. Structure for the quality testing of substrate wafers (30) of semiconductor material, produced from a larger semiconductor crystal, which are intended to be the basic material for the production of chips, the chips being provided for an integrated circuit, which is to be produced on them, with a specified layout density of field-effect transistors, this structure being introduced onto and/or into the surface of the substrate wafer (30) and this structure comprising field-effect transistor structures (21) conductor path structures (3) and pad structures (6), characterised

   - in that a large number of field-effect transistor structures (21) are laterally arranged at least as densely side by side as the field-effect transistors in the integrated circuit that is to be produced on the corresponding chip,
   - in that every field-effect transistor structure (21) has a dedicated well structure (23) and a dedicated source structure and dedicated drain structure (22) for its own exclusive use,
   - in that pad structures (7) individually associated with the individual field-effect transistor structures (21) are arranged in the edge region (6) of the structure, (21),
   - in that each individual source/drain structure (22) is connected to the respective pad structure (7) by a dedicated conductor path (3), the totality of these conductors paths having dimensions in width and/or length such that the resistance of each of the conductor paths is sufficiently equal for quality assessment, and
   - in that only one common gate conductor path (10, 11, 24) is provided.

2. Structure according to Claim 1, characterised in that, with respect to the side-by-side arrangement (2) of the field-effect transistor structures (21), a double-sided feed (10, 11) is provided for the gate conductor path structure.

3. Structure according to Claim 1 or 2, characterised in that a Schottky gate contact is provided.

4. Structure according to Claim 1, 2 or 3, characterised in that a path extension is provided in the conductor paths (3), in the form of a meandering structure (8).

5. Structure according to Claim 1, 2 or 3, characterised in that a path extension is provided in the conductor paths (3), in the form of a Zigzag (19).

6. Structure according to one of Claims 1 to 5, characterised by the conductor paths being arranged in a manner such that there are no crossings.

7. Structure according to one of Claims 1 to 6, characterised by a configuration with no insulation layer.

8. Structure according to one of Claims 1 to 7, characterised by the substrate wafer (30) having a surface that is free of etching structure.

9. Structure according to one of Claims 1 to 8, characterised in that the respective well structure (23) is a conductive, doped region.

10. Structure according to one of Claims 1 to 9, characterised in that the semiconductor material surrounding the respective well structure (23) is electrically insulating.

## Revendications

1. Structure pour contrôler la qualité de pastilles de substrat (30) assez étendues, formées d'un cristal d'un matériau semiconducteur et qui sont prévues comme matériau de départ pour des microplaquettes devant être fabriquées à partir de cette pastille, les microplaquettes étant prévues pour un circuit intégré devant être fabriqué sur elles-mêmes et comportant des transistors à effet de champ disposés avec une densité prédéterminée, et dans laquelle cette structure est disposée sur ou dans la surface de la pastille de substrat (30) et comprend des structures (21) de transistors à effet de champ, des structures (3) de voies conductrices et des structures de plots (6), caractérisée par le fait

   - qu'une multiplicité de structures (21) de transistors à effet de champ sont disposées latéralement côte-à-côte avec une densité au moins égale à la disposition des transistors à effet de champ dans le circuit intégré devant être fabriqué sur la microplaquette correspondante,
   - que chaque structure (24) de transistor à effet de champ possède en soi respectivement une structure propre en forme de cuvette (23) et une structure propre de source et une structure propre de drain (22),
   - que des structures de plots (7), associées individuellement aux différentes structures (21) de transistors à effet de champ, sont disposées dans la zone marginale (6) de la structure,

- que chaque structure individuelle de source/drain (22) est raccordée à la structure respective de plot (7) par une voie conductrice particulière (3), la largeur et/ou la longueur de l'ensemble de ces voies conductrices étant dimensionnées de manière à obtenir des voies conductrices ayant des résistances respectives identiques et suffisantes pour l'évaluation de la qualité, et

- qu'il n'est prévu qu'une seule voie conductrice (10,11,24) commune pour les grilles.

2. Structure suivant la revendication 1, caractérisée par le fait qu'en rapport avec la disposition côte-à-côte (2) des structures (21) des transistors à effet de champ, il est prévu une alimentation bilatérale (10,11) de la structure des voies conductrices des grilles.

3. Structure suivant la revendication 1 ou 2, caractérisée par le fait qu'il est prévu un contact de grille Schottky.

4. Structure suivant la revendication 1, 2 ou 3, caractérisée par le fait qu'il est prévu, dans les voies conductrices (3), un allongement du trajet sous la forme d'une structure sinueuse (8).

5. Structure suivant la revendication 1, 2 ou 3, caractérisée par le fait qu'il est prévu, dans les voies conductrices (3), un allongement sous la forme d'une disposition en va-et-vient (19).

6. Structure suivant l'une des revendications 1 à 5, caractérisée par une disposition croisée des voies conductrices.

7. Structure suivant l'une des revendications 1 à 6, caractérisée par une réalisation sans couche isolante.

8. Structure suivant l'une des revendications 1 à 7, caractérisée par le fait que la surface de la pastille de substrat (30) ne présente aucune structure formée par corrosion.

9. Structure suivant l'une des revendications 1 à 8, caractérisée par le fait que la structure respective en forme de cuvette (23) est une région dopée de manière à être conductrice.

10. Structure suivant l'une des revendications 1 à 9, caractérisée par le fait que le matériau semiconducteur entourant la structure respective en forme de cuvette (23) est électriquement isolant.

FIG 1a

# FIG1b

## FIG 2

2μm    5μm

21
22
23
23
24
25
25
26
27
2

## FIG 3

1
31
1
31
31
30